# EUROPEAN PATENT APPLICATION

(11) **EP 2 273 559 A1**
(43) Date of publication of application: **12.01.2011**
(21) Application number: 09734038.4
(22) Date of filing: 24.04.2009
(51) Int. Cl.: H01L 31/04

(54) **SOLAR CELL**

(30) Priority: 25.04.2008 JP 2008115981
(71) Applicant: Ulvac, Inc., Chigasaki-shi Kanagawa 253-8543 (JP)
(72) Inventor: WATAI, Miwa, Sammu Chiba 289-1226 (JP); SAITO, Kazuya, Sammu Chiba 289-1226 (JP); KOMATSU, Takashi, Sammu Chiba 289-1226 (JP); IDE, Yoshio, Sammu Chiba 289-1226 (JP); ASARI, Shin, Sammu Chiba 289-1226 (JP); MIZUNO, Yusuke, Sammu Chiba 289-1226 (JP); SHIMIZU, Miho, Sammu Chiba 289-1226 (JP)
(74) Representative: Eisenführ, Speiser & Partner
(86) International application number: PCT/JP2009/058163
(87) International publication number: WO 2009/131212

(57) **Abstract**

A solar cell (10) includes: a substrate (11) having optical transparency; a photoelectric converter provided on the substrate (11), including a top-face electrode (13) having optical transparency, a photoelectric conversion layer (14), and a back-face electrode (15) having light reflectivity; and a low-refractive conductive layer (16) whose refractive index is less than or equal to 2.0, the low-refractive conductive layer (16) being made of a conductive material having optical transparency, being adjacent to the photoelectric conversion layer (14), and being disposed on a side of the photoelectric conversion layer (14) opposite to the substrate (11).

## Description

### BACKGROUND OF THE INVENTION

### Field of the present invention

The present invention relates to a solar cell.

This application claims priority from Japanese Patent Application No. 2008-115981 filed on April 25, 2008, the contents of which are incorporated herein by reference in their entirety.

### Background Art

In recent years, in view of efficient use of energy, solar batteries are more widely used than ever before.

As solar cells, silicon-series solar cells such as a silicon solar cell employing single-crystalline silicon, a polysilicon solar cell employing polysilicon layer, or an amorphous silicon solar cell employing an amorphous silicon are known.

A silicon-series solar cell is constituted of a photoelectric converter in which, for example, a transparent electrode which serves as a top-face electrode and which is formed at a light receiving face of a glass substrate and composed of TCO (transparent conducting oxide) or the like, a semiconductor layer (photoelectric conversion layer) which is formed on the top-face electrode and composed of silicon, and an Ag thin film which is formed as a back-face electrode are stacked in layers.

The semiconductor layer has a layered structure which is referred to as pin-junction in which a silicon film (i-type) is sandwiched between p-type and n-type silicon films, the silicon film (i-type) generating electrons and holes when receiving light.

Consequently, sunlight that is incident to the glass substrate firstly passes through the top-face electrode and is supplied to the semiconductor layer.

At this time, when an energy particle which is referred to as photon included in sunlight is incident to the i-type, an electron and a hole are generated by the photovoltaic effect. The electron moves toward the n-type, and the hole moves toward the p-type.

The foregoing the electron and the hole are obtained from the top-face electrode and the back-face electrode, respectively, it is thereby possible to convert optical energy into electrical energy.

On the other hand, light that passed through the semiconductor layer is reflected by the top face of the back-face electrode and supplied to the semiconductor layer again, therefore, the electrons and the holes are generated in the semiconductor layer again, and optical energy is converted into electrical energy.

However, in the light that is incident to the back-face electrode after passing through the semiconductor layer in the above-described solar cell, most portion of the light is reflected by a boundary face between the semiconductor layer and the back-face electrode, and a portion of light slightly enters the back-face electrode.

As a result, an absorption loss occurs at the boundary face between the semiconductor layer and the back-face electrode, which is caused by light entering the back-face electrode, there is a problem in that power generation efficiency of the solar cell is degraded.

In addition, in the case where the back-face electrode is stacked on the semiconductor layer in layers, there is a concern that the constituent material (for example, Ag) of the back-face electrode diffuses in the semiconductor layer.

Consequently, in order to improve the reflectance, prevent the constituent material of the back-face electrode from being diffused in the semiconductor layer, or the like, a transparent electrode such as GZO (ZnO in which Ga is doped) may be formed between the back-face electrode and the semiconductor layer.

In this case, the sunlight that passed through the semiconductor layer is separated into light that is again supplied to the semiconductor layer after being totally-reflected by the boundary face between the semiconductor layer and the transparent electrode, and light that is again supplied to the semiconductor layer after passing through the transparent electrode and being reflected by the boundary face between the transparent electrode and the back-face electrode.

Because of this, since it is possible to reflect sunlight before the sunlight is incident to the back-face electrode in the pathway of light that is incident to the solar cell, it is believed that an absorption loss at the boundary face between the semiconductor layer and the back-face electrode decreases, and the power generation efficiency of the solar cell can be improved.

However, the difference between a refractive index of the transparent electrode (for example, the refractive index of GZO is n = 2.05 or more) and a refractive index of the semiconductor film (for example, the refractive index of a Si film is approximately n = 3.8 to 4.0) is small, and the percentage of the total reflection at the boundary face between the semiconductor layer and the transparent electrode is low.

Specifically, sunlight that is incident to the transparent electrode at a small incidence angle is only refracted at the boundary face between the semiconductor layer and the transparent electrode without satisfying the conditions for total reflection.

For this reason, the refracted sunlight passes through the transparent electrode and is incident to the back-face electrode.

That is, there is problem in that the reflectance is low at the transparent electrode.

For example, as disclosed in Japanese Unexamined Patent Application, First Publication No. 2007-266095, a structure in which a refractive-index controlling layer is inserted between the back-face electrode and the transparent electrode composed of GZO or the like is known, the refractive-index controlling layer being composed of SiO₂ whose refractive index is less than that of the transparent electrode and having a thickness of 5 to 25 nm.

However, in the above-described conventional technique, since the film thickness of the refractive-index controlling layer is relatively small, it is difficult to adjust the film thickness of the refractive-index controlling layer in manufacturing so as to be a film thickness which is considered in view of an optical distance or the like between the semiconductor layer and the back-face electrode.

In addition, though the refractive-index controlling layer can prevent the constituent material of the back-face electrode from being diffused in the semiconductor layer, an optical effect such that the reflectance is improved by the above-described film thickness of the refractive-index controlling layer is not obtained.

In addition, by inserting the refractive-index controlling layer between the photoelectric conversion layer and the back-face electrode layer in addition to the transparent electrode composed of GZO or the like, the number of steps of manufacturing solar cells increases, and there is problem in that the manufacturing efficiency is degraded.

### SUMMARY OF THE INVENTION

Therefore, the present invention was made in order to solve the above problems, and has an object to provide a solar cell in which it is possible to improve a reflectance at a boundary face between a low-refractive conductive layer and a photoelectric conversion layer, and it is possible to suppress an increase in manufacturing processes.

In order to solve the above-described problem, a solar cell of the present invention includes: a substrate having optical transparency; a photoelectric converter provided on the substrate, including a top-face electrode having optical transparency, a photoelectric conversion layer, and a back-face electrode having light reflectivity; and a low-refractive conductive layer whose refractive index is less than or equal to 2.0, the low-refractive conductive layer being made of a conductive material having optical transparency, being adjacent to the photoelectric conversion layer, and being disposed on a side of the photoelectric conversion layer opposite to the substrate.

With this configuration, since the refractive index of the low-refractive conductive layer is less than or equal to 2.0, it is possible to increase the difference between the refractive index of the photoelectric conversion layer and the refractive index of the low-refractive conductive layer, compared to the generally-used transparent electrode (the refractive index is n = 2.05 or more).

Consequently, it is possible to improve the percentage of total reflection at the boundary face between the photoelectric conversion layer and the low-refractive conductive layer.

For this reason, light having a low incidence angle with respect to the low-refractive conductive layer also satisfies the conditions for total reflection, it is possible to improve a reflectance at the boundary face between the photoelectric conversion layer and the low-refractive conductive layer.

Therefore, since it is possible to improve a reflectance of light, it is possible to improve power generation efficiency.

In addition, in the solar cell of the present invention, it is preferable that the low-refractive conductive layer be provided between the photoelectric conversion layer and the back-face electrode, and the low-refractive conductive layer be only provided between the photoelectric conversion layer and the back-face electrode.

With this configuration, the light passing through the photoelectric conversion layer is reflected in front of the back-face electrode in the pathway of light that is incident to the solar cell, it is possible to suppress the amount of light that passes through the low-refractive conductive layer and is incident to the back-face electrode.

By means of this structure, it is possible to reduce an absorption loss of light at the back-face electrode.

In this structure, by providing only the low-refractive conductive layer between the photoelectric conversion layer and the back-face electrode, it is possible to suppress an increase in manufacturing processes and to maintain manufacturing efficiency, compared to a conventional structure in which a refractive-index controlling layer is provided between the photoelectric conversion layer and the back-face electrode in addition to the transparent electrode.

In addition, since the low-refractive conductive layer is provided adjacent to the photoelectric conversion layer, it is possible to prevent the constituent material of the back-face electrode from being diffused in the photoelectric conversion layer.

In addition, in the solar cell of the present invention, it is preferable that the low-refractive conductive layer have a structure in which dopants are doped onto SiO₂.

With this configuration, since SiO₂ is adopted as the material of the low-refractive conductive layer, it is possible to lower the refractive index of the low-refractive conductive layer to approximately 1.5.

Consequently, by introducing dopants onto SiO₂ it is possible for the SiO₂ to be conducive.

For this reason, it is not necessary to form a low-refractive conductive layer with a thin-thickness in order to ensure the conduction between a layer adjacent to the photoelectric conversion layer (for example, back-face electrode) via the low-refractive conductive layer, and the photoelectric conversion layer, or it is not necessary to form a contact hole or the like on the low-refractive conductive layer in order to make contact between both of the layers.

Therefore, it is possible to easily form the low-refractive conductive layer in a state where an optical distance or the like is considered, while maintaining improvement of reflectance at the boundary face between the low-refractive conductive layer and the photoelectric conversion layer.

According to the present invention, since the refractive index of the low-refractive conductive layer is less than or equal to 2.0, it is possible to increase the difference between the refractive index of the photoelectric conversion layer and the refractive index of the low-refractive conductive layer, compared to a generally-used transparent electrode (the refractive index is n = 2.05 or more).

Consequently, it is possible to improve the percentage of total reflection at the boundary face between the photoelectric conversion layer and the low-refractive conductive layer.

For this reason, light that is incident to the low-refractive conductive layer by a low incidence angle also satisfies the conditions for total reflection, it is possible to improve a reflectance at the boundary face between the photoelectric conversion layer and the low-refractive conductive layer.

Therefore, since it is possible to improve a reflectance of light, it is possible to improve power generation efficiency.

### BRIEF DESCRIPTION OF THE DRAWINGS

FIG. 1 is a cross-sectional view showing an amorphous silicon type solar cell of an embodiment of the present invention.
FIG. 2 is a diagram illustrating a measurement result of a simulation test under Condition 1 and indicating reflectance (%) relative to wavelength (nm).
FIG. 3 is a diagram illustrating a measurement result of a simulation test under Condition 2 and indicating reflectance (%) relative to wavelength (nm).
FIG. 4 is a diagram illustrating a measurement result of a simulation test under Condition 3 and indicating reflectance (%) relative to wavelength (nm).

### DESCRIPTION OF THE PREFERRED EMBODIMENTS

Next, a solar cell related to an embodiment of the present invention will be described with reference to drawings.

### Solar Cell

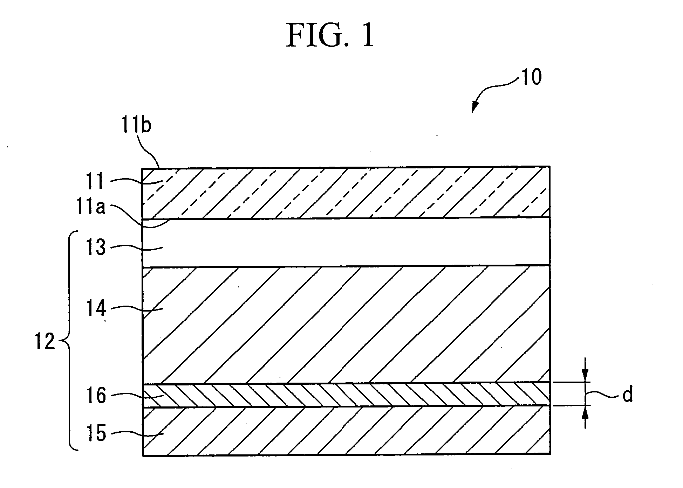

FIG. 1 is a cross-sectional view showing an amorphous silicon type solar cell.

As shown in FIG. 1, a solar cell 10 is a so-called single type solar cell having a photoelectric converter 12 formed on a face 11 a (hereinafter, refer to back face 11 a) of a transparent substrate 11 which has insulation properties.

The substrate 11 is composed of an insulation material having a high level of translucency of sunlight and durability, such as glass or a transparent resin. The length of the substrate 11 is, for example, approximately 3500 mm.

In the solar cell 10, sunlight is incident to a side opposite to the substrate face to which the photoelectric converter 12 faces, that is, the other face 11 b of the substrate 11 (hereinafter, refer to top face 11b).

The photoelectric converter 12 is configured to hold a semiconductor layer 14 (photoelectric conversion layer) between a top-face electrode 13 and a back-face electrode 15 and is formed on the entire area of the substrate 11 except a periphery of the back face 11 a.

The top-face electrode 13 is composed of a metal oxidative product having optical transparency, for example, a so-called TCO (transparent conducting oxide) such as GZO or ITO (Indium Tin Oxide) and is formed on the back face 11 a of the substrate 11.

The semiconductor layer 14 is formed on the top-face electrode 13.

The semiconductor layer 14 has a pin-junction structure in which, for example, an i-type amorphous silicon film (not shown in the figure) is sandwiched between a p-type amorphous silicon film (not shown in the figure) and an n-type amorphous silicon film (not shown in the figure).

In the pin-junction structure, the p-type amorphous silicon film, the i-type amorphous silicon film, and the n-type amorphous silicon film are stacked on the top-face electrode 13 in layers in this order.

When sunlight is incident to the semiconductor layer 14 and an energy particle that is included in sunlight is incident to the i-type amorphous silicon film, an electron and a hole are generated by the photovoltaic effect.

Then, the electron moves toward the n-type amorphous silicon film, and the hole moves toward the p-type amorphous silicon film.

The foregoing the electron and the hole are obtained from the top-face electrode 13 and the back-face electrode 15, respectively, it is thereby possible to convert optical energy into electrical energy (photoelectric conversion).

The back-face electrode 15 is stacked on a side of the semiconductor layer 14 opposite to the top-face electrode 13.

The back-face electrode 15 is composed of a conductive metal film such as Ag or Cu, and is formed by preferably using, for example, a low-temperature calcined nano-ink metal (Ag).

The back-face electrode 15 also has a function as a reflection layer that reflects sunlight passing through the semiconductor layer 14 and supplies the sunlight to the semiconductor layer 14 again.

In addition, it is preferable that the above-described photoelectric converter 12 have a texture structure in which micro irregularities are formed on the top face and the back face of each layer which are not shown in the figure.

In this case, since prism effect that the optical path of sunlight incident to each layer is extended and effect that light is confined can be achieved, it is possible to improve conversion efficiency of the optical energy of the solar cell 10.

Here, a low-refractive conductive layer 16 is provided between the semiconductor layer 14 and the back-face electrode 15.

In other words, the low-refractive conductive layer 16 is adjacent to the photoelectric conversion layer 12 and disposed on a face of the photoelectric conversion layer 12 opposite to the substrate 11.

The low-refractive conductive layer 16 is formed on the entire face of the n-type amorphous silicon film of semiconductor layer 14.

The low-refractive conductive layer 16 is only formed between the semiconductor film 14 and the back-face electrode 15.

As a material adopted to the low-refractive conductive layer 16, a low resistance material is preferably used, having a barrier property that the constituent material of the back-face electrode 15 is prevented from being diffused in the semiconductor layer 14 and a conductivity that an electrical conduction between the back-face electrode 15 and the semiconductor layer 14 is maintained.

In addition, it is preferable that the refractive index n of the low-refractive conductive layer 16 be less than or equal to 2.0 in order to increase the percentage of total reflection at the boundary face between the semiconductor layer 14 and the low-refractive conductive layer 16.

Specifically, it is preferable that the refractive index n be 1.4 to 1.9, and the film thickness d (reference to FIG. 1) be 40 nm to 80 nm.

In addition, it is further preferable that the refractive index n be 1.44 to 1.50 and the film thickness d be 50 nm to 75 nm.

As described above, since the low-refractive conductive layer 16 is formed so that the refractive index n thereof is less than or equal to 2.0, it is possible to increase the difference between the refractive index (n = 3.8 to 4.0) of the semiconductor layer 14 and the refractive index of the low-refractive conductive layer 16.

Consequently, it is possible to improve the percentage of total reflection at the boundary face between the semiconductor layer 14 and the low-refractive conductive layer 16.

Because of this, light having a low incidence angle with respect to the low-refractive conductive layer 16 also satisfies the conditions for total reflection, and it is possible to reflect sunlight incident to the low-refractive conductive layer 16 with high degree of efficiency at the boundary face between the semiconductor layer 14 and the low-refractive conductive layer 16.

In addition, by forming the low-refractive conductive layer 16 having the film thickness d of 40 nm or more, it is possible to easily adjust the film thickness of the low-refractive conductive layer 16 in manufacturing so as to be the film thickness which is considered in view of an optical distance or the like between the semiconductor layer 14 and the back-face electrode 15.

In addition, the back-face electrode 15 is prevented from being diffused in the semiconductor layer 14, and it is possible to improve the reflectance due to the low-refractive conductive layer 16.

On the other hand, by forming the low-refractive conductive layer having a film thickness of 80 nm or less, it is possible to maintain the transmissivity of sunlight in the low-refractive conductive layer 16.

For this reason, it is possible to prevent sunlight from being absorbed by the low-refractive conductive layer 16.

SiO₂ is preferably employed as the constituent material of the low-refractive conductive layer 16 of the foregoing embodiment, and the conductivity thereof is obtained by introducing dopants onto SiO₂.

Since the low-refractive conductive layer 16 is formed on the n-type amorphous silicon film of the semiconductor layer 14, it is preferable that an n-type dopant be used as the dopant which is doped onto SiO₂ of the low-refractive conductive layer 16. Therefore, it is possible to prevent the diffusion in the semiconductor layer 14.

As an n-type dopant, for example, phosphorus (P), arsenicum (As), antimony (Sb), bismuth (Bi), lithium (Li), magnesium (Mg), or the like may be adopted.

In addition, in a case where a high-temperature baking is not performed when forming the low-refractive conductive layer 16 or the back-face electrode 15, since the dopants are hardly diffused in the semiconductor layer 14, a p-type dopant may be doped onto the semiconductor layer 14 instead of n-type dopant.

As a p-type dopant, for example, boron (B), gallium (Ga), aluminum (Al), indium (In), thallium (T1), beryllium (Be), or the like may be adopted.

As described above, since SiO₂ is used as the constituent material of the low-refractive conductive layer 16, the low-refractive conductive layer 16 have a barrier property that diffusion is prevented and a conductivity, and it is possible to set the refractive index n of the low-refractive conductive layer 16 to be approximately 1.46.

In addition, as a method for forming the above-described low-refractive conductive layer 16, a sputtering method, a CVD method (chemical vapor deposition method), evaporation coating method, or the like may be adopted, and the method is performed on the substrate 11 on which the semiconductor layer 14 was formed.

In addition, in addition to the foregoing method, a method for baking a paste material after the paste material is applied can be applicable.

In the case where a film formation is performed by a sputtering method, it is preferable that a target in which dopants were doped in advance be employed.

In addition, in the case of the CVD method, it is preferable that a film be formed while a material gas as dopant is introduced into a chamber.

In addition, in the case of using the paste material, after applying the constituent material of the low-refractive conductive layer 16 and the above-described constituent material of the back-face electrode 15, both of them can be collectively baked.

In addition, as a material satisfying the condition of the above-described low-refractive conductive layer 16, a material in which the above-described dopants are doped onto SiO, MgF₂ (n = 1.37), Al₂O₃ (n = 1.65), or the like as well as SiO₂ may be adopted.

### Simulation Test

Here, the inventors set various conditions for forming a layer between a semiconductor layer and a back-face electrode, performed simulation tests of measuring reflectances of solar cells formed by the conditions, and compared simulation results with each other.

The solar cell of the present test had a structure in which a transparent electrode composed of ZnO was provided between the semiconductor layer and the back-face electrode, or had a structure in which a low-refractive conductive layer in which an n-type dopant was doped onto SiO₂ is provided instead of a transparent electrode.

In addition, relative to light that passed through the semiconductor layer, the reflectance represents the percentage of light that was reflected at the boundary face between the semiconductor layer and the transparent electrode or the low-refractive conductive layer and the percentage of light that was reflected at the boundary face between the transparent electrode or the low-refractive conductive layer and the back-face electrode.

The test conditions of the present test are described as follows.

In addition, a solar cell of Condition 1 indicates a structure of a conventional solar cell, and a solar cell of Condition 3 indicates a structure of the solar cell of the embodiment.

In contrast, a solar cell of Condition 2 indicates a structure in which the film thickness of the solar cell of Condition 3 is varied.

### Condition 1: Layered structure (substrate / top-face electrode / semiconductor layer / transparent electrode (ZnO) / back-face electrode)

The refractive index n of the transparent electrode: 2.05.

The film thickness d of the transparent electrode: 80.0 nm

### Condition 2: Layered structure (substrate / top-face electrode / semiconductor layer / low-refractive conductive layer (n-type dopant is doped in SiO₂) / back-face electrode)

The refractive index n of the low-refractive conductive layer: 1.46

The film thickness d of the low-refractive conductive layer: 8.0 nm

### Condition 3: Layered structure (substrate / top-face electrode / semiconductor layer / low-refractive conductive layer (n-type dopant is doped in SiO₂) / back-face electrode)

The refractive index n of the low-refractive conductive layer: 1.46

The film thickness d of the low-refractive conductive layer: 54.5 nm

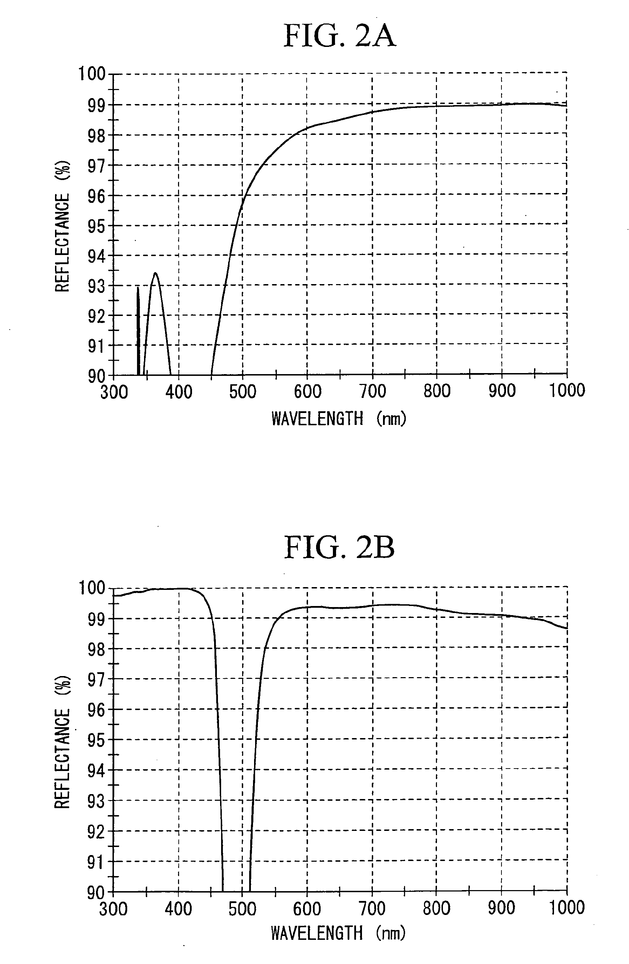

FIG. 2(a) to FIG. 4(b) are diagrams showing reflectance (%) relative to wavelength (nm).

FIGS. 2(a), 3(a), and 4(a) show reflectances in the case where the incidence angle was 0°, and FIGS. 2(b), 3(b), and 4(b) show reflectances in the case where the incidence angle was 45°.

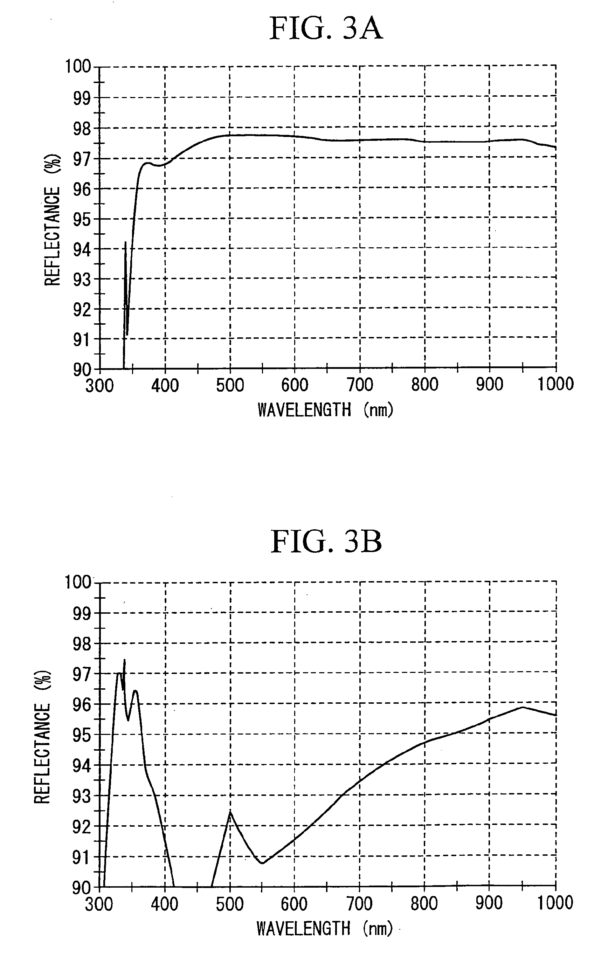

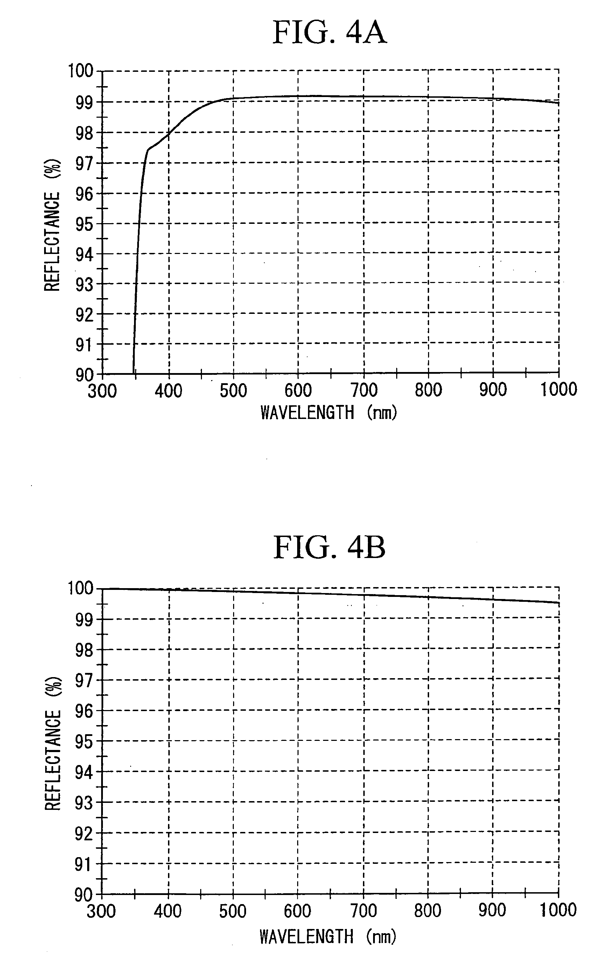

FIGS. 2(a) and 2(b) show reflectances in the case of Condition 1, FIGS. 3(a) and 3(b) show reflectances in the case of Condition 2, and FIGS. 4(a) and 4(b) show reflectances in the case of Condition 3.

Firstly, in the simulation results under Condition 1 as shown in FIG. 2(a), the reflectance was low, for example, 95% or less in a low-wavelength region (for example, wavelength of 300 to 500 nm), and the reflectance became high in a manner so as to move toward a high-wavelength region (for example, wavelength of 600 nm or more).

It is believed that, the reflectance is low in the low-wavelength region, is due to a phase difference between light that was reflected at the boundary face between the transparent electrode and the semiconductor layer, and light that was reflected at the boundary face between the back-face electrode and the transparent electrode exists, both lights thereby interfere with each other and cancel each other, as a result, the light was not supplied to the semiconductor layer.

In addition, it is believed that the reflectance does not become 100% because, in the light that was incident to the back-face electrode after passing through the transparent electrode, most of the light was reflected by the boundary face between the transparent electrode and the back-face electrode, but part of light slightly entered the back-face electrode, and there is absorption loss such that light is absorbed by the back-face electrode.

On the other hand, as shown in FIG. 2(b), the reflectance in the case where the incidence angle was 45° sharply decreases in the vicinity of wavelength of 500 nm.

It is believed that, as described above, this is due to interference which is caused by the phase difference between light that was reflected at the boundary face between the transparent electrode and the semiconductor layer and light that was reflected at the boundary face between the transparent electrode and the back-face electrode, an absorption loss in the back-face electrode, or the like.

Secondly, in the simulation results under Condition 2 as shown in FIG. 3(a), substantially constant reflectance was obtained in a low-wavelength region and from the low-wavelength region to the high-wavelength region, however, the reflectance was lower than that of Condition 1.

On the other hand, as shown in FIG. 3(b), regarding the reflectance in the case where the incidence angle was 45°, the reflectance was totally-low from the low-wavelength region to the high-wavelength region, there was variations in the reflectance.

It is believed that, this is due to, in the case where the film thickness was relatively low, the interference which was caused by the phase difference between the light that was reflected at boundary face between the transparent electrode and the semiconductor layer and the light that was reflected at the boundary face between the transparent electrode and the back-face electrode easily occurs, in addition to an absorption loss at the back-face electrode.

That is, in the case where the film thickness was approximately 8 nm, it was difficult to adjust the film thickness of the low-refractive conductive layer so as to be the film thickness which was considered in view of an optical distance or the like between the semiconductor layer and the back-face electrode as described above, and an optical effect such that reflectance is improved was not obtained.

Subsequently, in the simulation results under Condition 3 as shown in FIG. 4(a), when the incidence angle was 0°, it was possible to obtain totally-uniform reflectance from the low-wavelength region to the high-wavelength region, specifically, the reflectance was approximately 99%.

On the other hand, as shown in FIG. 4(b), regarding the reflectance in the case where the incidence angle was 45°, it was possible to obtain reflectance of approximately 100% in whole from the low-wavelength region to the high-wavelength region.

In addition, in the simulation results where the thickness of the low-refractive conductive layer was equal to the film thickness (80 nm) under Condition 1 (not shown in the figure), an excellent result that reflectance was improved as compared with Condition 1 was obtained.

As mentioned above, the solar cell 10 of the embodiment has the structure in which the low-refractive conductive layer 16 whose refractive index n is less than or equal to 2.0 is provided between the semiconductor layer 14 and the back-face electrode 15.

With this configuration, by providing the low-refractive conductive layer 16 between the semiconductor layer 14 and the back-face electrode 15, it is possible to prevent the constituent material of the back-face electrode 15 from being diffused in the semiconductor layer 14.

Particularly, by setting the refractive index of the low-refractive conductive layer 16 to be less than or equal to 2.0, it is possible to increase a difference between the refractive index of the semiconductor layer 14 and the refractive index of the low-refractive conductive layer 16 as compared with the case where commonly-used transparent electrode (refractive index n is 2.05 or more) is provided.

Consequently, it is possible to improve the percentage of total reflection at the boundary face between the semiconductor layer 14 and the low-refractive conductive layer 16.

Because of this, light having a low incidence angle with respect to the low-refractive conductive layer 16 also satisfies the conditions for total reflection, for this reason, it is possible to improve the reflectance at the boundary face between the semiconductor layer 14 and the low-refractive conductive layer 16.

In addition, in the pathway of light that is incident to the solar cell, by reflecting the light that passes through the semiconductor layer 14 in front of the back-face electrode 15, it is possible to suppress the amount of light that passes through the low-refractive conductive layer 16 and is incident to the back-face electrode 15.

For this reason, it is possible to reduce an absorption loss of light at the back-face electrode 15.

As a result, since it is possible to improve a reflectance of the solar cell 10, it is possible to improve power generation efficiency.

In addition, by providing only the low-refractive conductive layer 16 between the semiconductor layer 14 and the back-face electrode 15, it is possible to suppress an increase in manufacturing processes and to maintain manufacturing efficiency as compared with a conventional case where a refractive-index controlling layer is provided between the semiconductor layer 14 and the back-face electrode 15 in addition to the transparent electrode.

Furthermore, by introducing dopants onto SiO₂ as the low-refractive conductive layer 16 of the embodiment, it is possible for the SiO₂ to be conductive.

For this reason, it is not necessary to form a low-refractive conductive layer with a thin-thickness in order to ensure the conduction between the back-face electrode 15 and the semiconductor layer 14, or it is not necessary to form a contact hole or the like on the low-refractive conductive layer in order to make contact between the semiconductor layer 14 and the back-face electrode 15.

Therefore, it is possible to easily form the low-refractive conductive layer 16 in a state where an optical distance or the like is considered while maintaining improvement of a reflectance at the boundary face between the low-refractive conductive layer 16 and the semiconductor layer 14.

In addition, the technical scope of the invention is not limited to the above embodiments, but various modifications may be made without departing from the scope of the invention in addition to the above embodiments.

That is, the structure or the like which are adopted in the above-described embodiment is an example, and the structure or the like may be appropriately modified.

For example, in the above-described embodiment, an amorphous silicon type solar cell is described, however, a microcrystalline silicon type solar cell or a crystal silicon (single-crystalline silicon, polysilicon) type solar cell can be adopted.

In addition, in the above-described embodiment, a single type solar cell is described, a tandem type solar cell in which amorphous silicon and microcrystalline silicon are held between a pair of electrodes can be adopted.

In the tandem type solar cell, short-wavelength light is absorbed by a first semiconductor layer (for example, amorphous silicon), long-wavelength light is absorbed by a second semiconductor layer (for example, microcrystalline silicon), and it is thereby possible to improve power generation efficiency.

In addition, by providing an intermediate electrode between the semiconductor layers, since part of light passing through the first semiconductor layer and reaching the second semiconductor layer is reflected by the intermediate electrode and is incident to the first semiconductor layer again, sensitivity characteristics of the photoelectric converter are improved, and intermediate electrode contributes improvement of power generation efficiency.

In this case, a structure in which a low-refractive conductive layer is provided between a back-face electrode and a semiconductor layer is applicable.

In addition, a structure in which the low-refractive conductive layer of the present invention is provided instead of the intermediate electrode provided between amorphous silicon and microcrystalline silicon is applicable.

### Industrial Applicability

As described in detail, the present invention is applicable to a solar cell in which it is possible to improve the reflectance at a boundary face between a low-refractive conductive layer and a photoelectric conversion layer, and it is possible to suppress an increase in manufacturing processes.

## Claims

1. A solar cell comprising:
a substrate having optical transparency;
a photoelectric converter provided on the substrate, including a top-face electrode having optical transparency, a photoelectric conversion layer, and a back-face electrode having light reflectivity; and
a low-refractive conductive layer whose refractive index is less than or equal to 2.0, the low-refractive conductive layer being made of a conductive material having optical transparency, being adjacent to the photoelectric conversion layer, and being disposed on a side of the photoelectric conversion layer opposite to the substrate.

2. The solar cell according to claim 1, wherein
the low-refractive conductive layer is provided between the photoelectric conversion layer and the back-face electrode, and the low-refractive conductive layer is only provided between the photoelectric conversion layer and the back-face electrode.

3. The solar cell according to any one of claims 1 and 2, wherein
the low-refractive conductive layer has a structure in which dopants are doped onto SiO₂.
